# EUROPEAN PATENT APPLICATION

(11) **EP 4 592 135 A1**
(43) Date of publication of application: **30.07.2025**
(21) Application number: 22959637.4
(22) Date of filing: 25.11.2022
(51) Int. Cl.: B60L 58/12, B60L 3/00, B60L 53/10, B60L 7/10, B60K 35/00, G01R 31/00, G01R 19/165, G01R 31/382, G01R 31/367

(54) **DEVICE FOR ESTIMATING CONDITION OF VEHICLE AND OPERATION METHOD THEREOF**

(30) Priority: 19.09.2022 KR 20220118197
(71) Applicant: LG Energy Solution, Ltd., Seoul 07335 (KR)
(72) Inventor: KIM, Kang San, Daejeon 34122 (KR); KIM, Geum Bee, Daejeon 34122 (KR); CHOI, Yo Hwan, Daejeon 34122 (KR)
(74) Representative: Goddar, Heinz J.
(86) International application number: PCT/KR2022/018834
(87) International publication number: WO 2024/063207

(57) **Abstract**

A vehicle state estimation apparatus according to an embodiment disclosed in this embodiment includes a current sensor and a processor, wherein the processor may be configured to obtain a current profile of a battery pack of a vehicle via a current sensor, extract a low-frequency component of a predetermined frequency or less from the current profile, and estimate a first flat section in which a current value is equal to or greater than a first predetermined current value and a change in current is maintained below a first threshold value over a predetermined period of time in the low-frequency component as a charging period of the battery pack.

## Description

### [TECHNICAL FIELD]

### CROSS-REFERENCE TO RELATED APPLICATION

This application claims priority to Korean Patent Application No. 10-2022-0118197, filed September 19, 2022, the entire contents of which is incorporated herein for all purposes by this reference.

### TECHNICAL FIELD

Embodiments disclosed in this document relate to a vehicle state estimation apparatus and an operation method thereof.

### [BACKGROUND ART]

Recently, research and development on secondary batteries have been actively conducted. Here, the secondary battery is a rechargeable battery and includes all of the conventional Ni/Cd batteries, Ni/MH batteries, and recent lithium ion batteries. Among the secondary batteries, Lithium ion batteries have an advantage of much higher energy density than the conventional Ni/Cd batteries and Ni/MH batteries. In addition, lithium-ion batteries can be manufactured small and lightweight enough to be used as power sources for mobile devices and recently expand their usage range to power sources for electric vehicles, attracting attention as a next-generation energy storage medium.

The electric vehicle may be in a driving or stationary state when the battery is discharged and even when the battery is recharged. That is, since whether the electric vehicle is in a driving state or not does directly match whether or not the battery is being charged or discharged, various signals must be collected to estimate the state of the electric vehicle.

### [DISCLOSURE]

### [TECHNICAL PROBLEM]

However, since the types and resolutions of signals that can be collected are different depending on the vehicle, a different method for estimating the state of the vehicle must be applied depending on the situation, which incurs a lot of cost and time.

An object of the embodiments disclosed in this document is to provide a vehicle state estimation apparatus and an operation method thereof that are capable of estimating a state of a vehicle.

An object of the embodiments disclosed in this document is to provide a vehicle state estimation apparatus and an operation method thereof that are capable of estimating a vehicle state based on current data of a battery pack.

An object of the embodiments disclosed in this document is to provide a vehicle state estimation apparatus and an operation method thereof that are capable of additionally correcting a state of the vehicle based on vehicle speed data.

The technical objects of the embodiments disclosed in this document are not limited to the aforesaid, and other objects not described herein will be clearly understood by those skilled in the art from the descriptions below.

### [TECHNICAL SOLUTION]

A vehicle state estimation apparatus according to an embodiment disclosed in this document includes a current sensor and a processor, wherein the processor may be configured to obtain a current profile of a battery pack of a vehicle via a current sensor, extract a low-frequency component of a predetermined frequency or less from the current profile, and estimate a first flat section in which a current value is equal to or greater than a first predetermined current value and a change in current is maintained below a first threshold value over a predetermined period of time in the low-frequency component as a charging period of the battery pack.

According to an embodiment disclosed in this document, the charging period may include a fast charging period and/or a slow charging period, and the processor may be configured to estimate at least part of the first flat section as the fast charging period or the slow charging section based on the current value of the first flat section.

According to an embodiment disclosed in this document, the processor may be configured to estimate a section in which the current value is equal to or greater than a second predetermined current value among the first flat section as the fast charging period and estimate a section in which the current value is less than the second predetermined current value in the first flat section as the slow charging period.

According to an embodiment disclosed in this document, the processor may be configured to estimate at least part of a second flat section in which a change in current is equal to or less than a second threshold value over a predetermined period of time in the current profile as a stop period of the vehicle.

According to an embodiment disclosed in this document, the processor may be configured to estimate a section in which the current value is equal to or less than 0 A (ampere) among the second flat section as the step period.

According to an embodiment disclosed in this document, the processor may be configured to extract a first section, excluding the first flat section and a second flat section in which a change in current is maintained less than or equal to a second threshold value over a predetermined period of time, in the current profile and estimate at least part of the first section as a driving period or a regenerative braking period of the vehicle based on the current value of the first section.

According to an embodiment disclosed in this document, the processor may be configured to estimate a second section in which the current value is a positive number among the first section as the regenerative braking period and estimate a third section in which the current value is a negative number among the first section as the driving period.

According to an embodiment disclosed in this document, the processor may be configured to acquire a parameter related to state the estimation of the vehicle and additionally correct the vehicle's state based on the parameter.

According to an embodiment disclosed in this document, the parameter may include the driving speed information of the vehicle.

The vehicle state estimation apparatus according to an embodiment disclosed in this document includes a display, wherein the processor may be configured to display information related to the state of the vehicle through the display.

In the vehicle state estimation apparatus according to an embodiment disclosed in this document, the processor may be configured to transmit data including information related to the state of the vehicle to an external electronic device by using a communication circuit, and the data may include at least one instruction causing the external electronic device to output a predetermined alarm including the information related to the state of the vehicle through a user interface.

A vehicle state estimation method according to an embodiment disclosed in this document may include acquiring a current profile of a battery pack of a vehicle, extracting extract a low-frequency component of a predetermined frequency or less from the current profile, and estimating a first flat section in which a current value is equal to or greater than a first predetermined current value and a change in current is maintained below a first threshold value over a predetermined period of time in the low-frequency component as a charging period of the battery pack.

According to an embodiment disclosed in this document, the charging period may include a fast charging period and/or a slow charging period, and estimating the first flat section may include estimating at least part of the first flat section as the fast charging period or the slow charging section based on the current value of the first flat section.

A vehicle state estimation method according to an embodiment disclosed in this document may include estimating at least part of a second flat section in which a change in current is equal to or less than a second threshold value over a predetermined period of time in the current profile as a stop period of the vehicle.

A vehicle state estimation method according to an embodiment disclosed in this document may include extracting a first section, excluding the first flat section and a second flat section in which a change in current is maintained less than or equal to a second threshold value over a predetermined period of time, in the current profile and estimate at least part of the first section as a driving period or a regenerative braking period of the vehicle based on the current value of the first section.

A vehicle state estimation method according to an embodiment disclosed in this document may include acquiring parameters related to the state estimation of the vehicle and correcting a state of the vehicle additionally based on the parameters.

### [ADVANTAGEOUS EFFECTS]

According to the embodiments disclosed in this document, it is possible to estimate the state of the vehicle reliably based on the current data of the battery pack.

According to the embodiments disclosed in this document, it is possible to improve the accuracy of estimating the state of the vehicle by additionally correcting the state of the vehicle based on the speed data of the vehicle.

In addition, various effects identified directly or indirectly through this document can be provided.

### [DESCRIPTION OF DRAWINGS]

FIG. 1 is a block diagram illustrating a vehicle including a vehicle state estimation apparatus according to an embodiment;
FIG. 2 is a flowchart illustrating an operation a vehicle state estimation apparatus according to an embodiment;
FIG. 3 is a flowchart illustrating an operation of a vehicle state estimation apparatus according to an embodiment;
FIG. 4 is a diagram illustrating an example of estimating a charging period of a battery pack by a vehicle state estimation apparatus according to an embodiment;
FIG. 5 is a flowchart illustrating an operation a vehicle state estimation apparatus according to an embodiment;
FIG. 6 is a diagram illustrating an example of estimating a stop period of a vehicle by a vehicle state estimation apparatus according to an embodiment;
FIG. 7 is a flowchart illustrating an operation of a vehicle state estimation apparatus according to an embodiment;
FIG. 8 is a diagram illustrating a screen provided through a display by a vehicle state estimation apparatus according to an embodiment.

### [MODE FOR INVENTION]

Hereinafter, various embodiments of the present invention will be described with reference to the accompanying drawings. However, the description is not intended to limit the present invention to particular embodiments, and it should be construed as including various modifications, equivalents, and/or alternatives of the embodiments described herein.

Various embodiments disclosed in this document and terms used therein are not intended to limit the technical features described in this document to specific embodiments, and the disclosure should be construed as including various modifications, equivalents, and/or alternatives of the corresponding embodiments. In connection with the description of the drawings, like reference numbers may be used for like or related elements. The singular form of a noun corresponding to an item may include one item or a plurality of items, unless the relevant context clearly dictates otherwise.

In this document, each of the phrases such as "A or B", "at least one of A and B", "at least one of A or B", "A, B or C", "at least one of A, B and C", and "at least one of A, B, or C" may include any of the items listed together in the corresponding phrase or any possible combination thereof. Terms such as "the first", "the second", "first", "second", "A", "B", "(a)", or "(b)" may be used simply to distinguish such components from other components and do not limit the corresponding components in other aspects (e.g., importance or order) unless otherwise stated specifically.

In this document, when it is mentioned that a (e.g., first) component is "connected", "coupled", "accessed", with or without the terms "functionally" or "communicatively", to another (e.g., second) component, it means that the component can be connected to the other component directly (e.g., wired), wirelessly, or via a third component.

According to an embodiment, the method according to various embodiments disclosed in this document may be provided in the form of a computer program product. The computer program product may be traded between sellers and buyers as commodities. The computer program product may be distributed in the form of a machine-readable storage medium (e.g., compact disc read only memory (CD-ROM)) or online (e.g., download or upload) via an application store or directly between two user devices. In the case of online distribution, at least part of the computer program product may be temporarily stored or temporarily created in a device-readable storage medium such as a manufacturer's server, an application store server, or a relay server's memory.

According to various embodiments, each component (e.g., module or program) of the components described above may include a single object or a plurality of objects, and some of the multiple objects may be separately disposed in other components. According to various embodiments, one or more components or operations among the aforementioned components may be omitted, or one or more other components or operations may be added. Alternatively or additionally, a plurality of components (e.g., modules or programs) may be integrated into a single component. In this case, the integrated component may perform one or more functions of each of the plurality of components identically or similarly to those performed by the corresponding component of the plurality of components prior to the integration. According to various embodiments, operations performed by modules, programs, or other components are executed sequentially, in parallel, iteratively, or heuristically, or one or more of the operations are executed in a different order, omitted, or one or more other operations may be added.

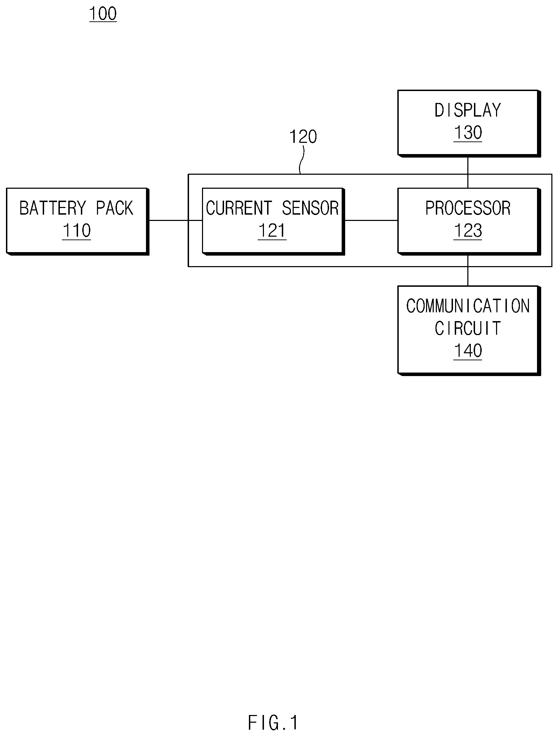

FIG. 1 is a block diagram illustrating a vehicle including a vehicle state estimation apparatus according to an embodiment.

Referring to FIG. 1, a vehicle 100 may include a battery pack 110, a vehicle state estimation apparatus 120, a display 130, and/or a communication circuit 140. According to an embodiment, the vehicle 100 may be an electric vehicle using electrical energy. According to an embodiment, the vehicle 100 may be configured with the omission of at least one of the components of FIG. 1 or the addition of one or more other components. According to an embodiment, some components may be implemented as a single integrated circuit.

According to an embodiment, the battery pack 110 may include a battery module including at least one battery cell and capable of being charged and discharged. In addition, the battery pack 110 may include a battery management system (BMS) performing functions of measuring electrical characteristic values such as current or voltage, controlling charge/discharge, controlling voltage equalization, estimating the state of charge (SOC), and estimating the state of health (SOH).

The vehicle state estimation apparatus 120 may include a current sensor 121 and/or a processor 123 .

The current sensor 121 may be electrically connected to the battery pack 110. According to an embodiment, the current sensor 121 may measure the current of the battery pack 110. The current sensor 121 may transmit the current profile of the battery pack 110 to the processor 123 based on the measured current value.

According to an embodiment, the current sensor 121 may receive a measurement control signal from the processor 123 to measure the current of the battery pack 110 while the charging current flows. The current sensor 121 may measure the current of the battery pack 110 whenever a measurement control signal is received from the processor 123.

The processor 123 may be electrically connected to the current sensor 121, the display 130, and/or the communication circuit 140. According to an embodiment, the processor 123 may execute software to control at least one other component connected to the processor 123 and may perform various data processing or operations. According to an embodiment, the processor 123 may control the overall operation of the vehicle state estimation apparatus 120 by controlling at least one other component connected to the processor 123. The processor 123 may include at least one of processing devices such as an application-specific integrated circuit (ASIC), a digital signal processor (DSP), a programmable logic device (PLD), a field programmable gate array (FPGA), a central processing unit (CPU), a microcontroller, or a microprocessor.

According to an embodiment, the processor 123 may obtain a current profile of the battery pack 110. According to an embodiment, the processor 123 may obtain a current profile of the battery pack 110 via the current sensor 121. For example, the processor 123 may obtain the current profile by measuring a current value of the battery pack 110 for a predetermined period of time via the current sensor 121.

According to an embodiment, the processor 123 may estimate the state of the vehicle based on the obtained current profile.

According to an embodiment, the processor 123 may extract a low-frequency component of a predetermined frequency or less from the obtained current profile. According to an embodiment, the processor 123 may extract a low-frequency component of a predetermined frequency or less using a low-pass filter (LPF).

According to an embodiment, the processor 123 may extract a first flat section from the obtained low-frequency component. According to an embodiment, the processor 123 may extract the first flat section from the low-frequency component using a standard deviation (STD) filter. Here, the STD filter may refer to a filter that extracts a section in which a standard deviation is equal to or less than a specified level in the current profile. According to an embodiment, the processor 123 extracts a first flat section in which the current value is equal to or greater than a first predetermined current value and the change in current is maintained below a first threshold value over a predetermined period of time in the low-frequency component using an STD filter.

According to an embodiment, the processor 123 may estimate the extracted first flat section as a charging period of the battery pack 110. Here, the charging period may mean a period in which the battery pack 110 receives power from an external power source. According to an embodiment, the processor 123 may estimate a section in which a current value is equal to or greater than a second predetermined current value among the extracted first flat sections as a fast charging period. The processor 123 may also estimate a section in which a current value is less than a second predetermined current value among the extracted first flat sections as a slow charging period. Here, the second predetermined current value may be greater than the first predetermined current value.

According to an embodiment, the processor 123 may extract the second flat section from the obtained current profile. According to an embodiment, the processor 123 may extract the second flat section from the current profile using the STD filter. According to an embodiment, the processor 123 may extract a second flat section in which a change in current is maintained less than or equal to a second threshold value over a predetermined period of time using an STD filter.

According to an embodiment, the processor 123 may estimate at least part of the extracted second flat section as a stop period of the vehicle 100. According to an embodiment, the processor 123 may estimate a section in which the current value is equal to or less than a third predetermined value among the second flat sections as the stop period of the vehicle 100. For example, the third predetermined value may be 0 A (ampere). In this case, the processor 123 may estimate a section in which the current value is 0 A and/or a section in which the current value is a negative number among the second flat section as the stop period of the vehicle 100. Here, a section in which the current value is negative may mean a period in which the current of the battery pack 110 flows in a direction in which the battery pack 110 is discharged.

According to an embodiment, the processor 123 may extract a first section excluding the first flat section and the second flat section in the current profile. The processor 123 may estimate at least part of the first section as a driving period or a regenerative braking period based on the current value of the first section. According to an embodiment, the processor 123 may estimate a second section in which the current value is a positive number among the first sections as a regenerative braking period. Also, the processor 123 may estimate a third section in which the current value is a negative number among the first sections as a driving period. Here, the section in which the current value is a positive number may mean a period in which the current of the battery pack 110 flows in a direction in which the battery pack 110 is charged, and the section in which the current value is a negative number may mean a period in which the current of the battery pack 110 flows in a direction in which the battery pack 110 is discharged.

According to an embodiment, the processor 123 may acquire parameters related to vehicle state estimation. According to an embodiment, the parameters related to vehicle state estimation may include driving speed information of the vehicle 100. For example, the driving speed information may include driving speed information of the vehicle 100 for a time corresponding to the current profile.

According to an embodiment, the processor 123 may additionally correct the state of the vehicle 100 based on the acquired parameters. According to an embodiment, the processor 123 may correct only a section in which the speed of the vehicle 100 is a predetermined value among the estimated charging period as a charging period. For example, the predetermined value may be set to 0 km/h. According to an embodiment, the processor 123 may correct only a section in which the speed of the vehicle 100 is a predetermined value among the estimated stop periods as a stop period. For example, the predetermined value may be set to 0 km/h. According to an embodiment, the processor 123 may correct only a section in which the speed of the vehicle 100 is equal to or greater than a predetermined value among the estimated driving periods as a driving period. For example, the predetermined value may be set to 1 km/h.

According to an embodiment, the processor 123 may provide the user with the vehicle state information. According to an embodiment, the processor 123 may provide the user with the vehicle state information estimated through the above-described operation and/or the vehicle state information corrected through the above-described operation.

According to one embodiment, the processor 123 may display the vehicle state information through the display 130. According to an embodiment, the processor 123 may transmit the vehicle state information to an external electronic device via the communication circuit 140. The external electronic device may display the received vehicle state information through the display of the external electronic device.

The display 130 may be disposed inside the vehicle 100. For example, the display 130 may be a liquid crystal display, a light emitting diode (LED) display, an organic LED (OLED) display, or an electronic ink (E-INK) display. The display 130 may display a user interface capable of manipulating and outputting various functions that can be executed in the vehicle 100. According to an embodiment, the display 130 may display a screen including the vehicle state information received from the processor 123.

The communication circuit 140 may transmit and receive data to and from an external electronic device and/or an external server in a wired or wireless manner. According to an embodiment, the communication circuit 140 may transmit data including the vehicle state information received from the processor 123 to an external electronic device and/or an external server. According to an embodiment, the data may include instructions that cause an external electronic device to output a designated alarm through a user interface (e.g., a display or a speaker).

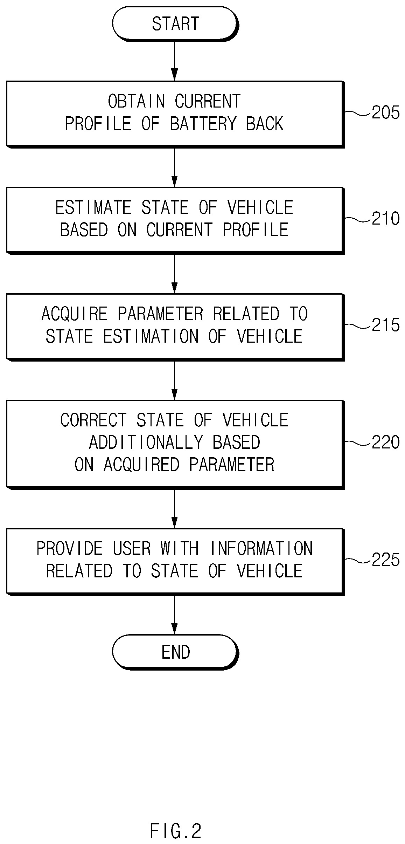

FIG. 2 is a flowchart illustrating an operation a vehicle state estimation apparatus according to an embodiment. FIG. 2 may be described with the components of FIG. 1.

The embodiment shown in FIG. 2 is only one embodiment, and the order of steps according to various embodiments of the present invention may be different from that shown in FIG. 2, and some steps shown in FIG. 2 may be omitted, changed in order, or merged.

According to one embodiment, it may be understood that operations 205 to 225 are performed by the processor 123 of the vehicle state estimation apparatus 120.

With reference to FIG. 2, in operation 205, the vehicle state estimation apparatus 120 may obtain a current profile of the battery pack 110. According to an embodiment, the vehicle state estimation apparatus 120 may obtain the current profile of the battery pack 110 via the current sensor 121. For example, the vehicle state estimation apparatus 120 may obtain the current profile by measuring a current value of the battery pack 110 for a predetermined period of time via the current sensor 121.

In operation 210, the vehicle state estimation apparatus 120 may estimate the state of the vehicle based on the current profile obtained in operation 205.

According to an embodiment, the vehicle state estimation apparatus 120 may extract a low-frequency component of a predetermined frequency or less from the current profile. The vehicle state estimation apparatus 120 may estimate a first flat section in which the current value is equal to or greater than the first predetermined current value and the change in current is maintained below the first threshold value over a predetermined period of time in the low-frequency component as the charging period.

According to an embodiment, the vehicle state estimation apparatus 120 may estimate at least part of the second flat section in which the change in current is maintained less than or equal to a second threshold value over a predetermined period of time in the current profile as a stop period of the vehicle 100.

According to an embodiment, the vehicle state estimation apparatus 120 may extract a first section excluding the first flat section and the second flat section. The vehicle state estimation apparatus 120 may estimate at least part of the first section as a driving period or a regenerative braking period of the vehicle based on the current value of the first section.

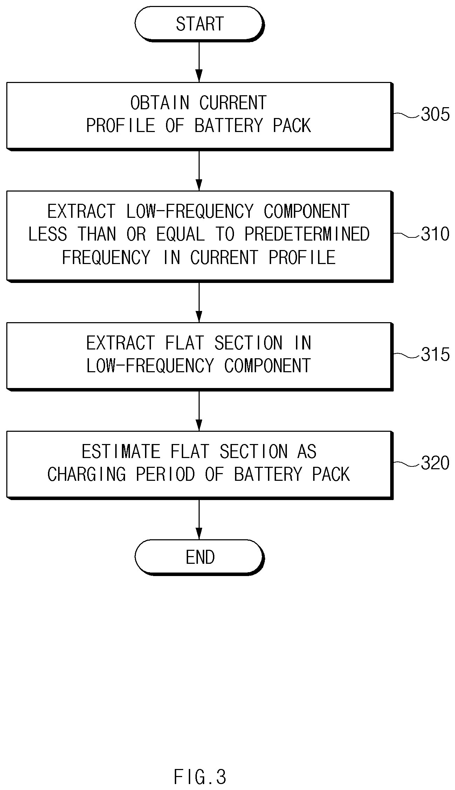

The operation in which the vehicle state estimation apparatus 120 estimate the vehicle state based on the current profile may be described later in detail with reference to FIGS. 3 to 7.

In operation 215, the vehicle state estimation apparatus 120 may acquire parameters related to vehicle state estimation. According to an embodiment, the parameters related to vehicle state estimation may include driving speed information of the vehicle 100. For example, the driving speed information may include driving speed information of the vehicle 100 for a time period corresponding to the current profile obtained in operation 205.

In operation 220, the vehicle state estimation apparatus 120 may additionally correct the state of the vehicle 100 based on the parameters acquired in operation 215.

According to an embodiment, the vehicle state estimation apparatus 120 may correct only a section in which the speed of the vehicle 100 is a predetermined value among the charging period estimated in operation 210 as a charging period. For example, the predetermined value may be set to 0 km/h.

According to an embodiment, the vehicle state estimation apparatus 120 may correct only a section in which the speed of the vehicle 100 is a predetermined value among the estimated stop periods as a stop period. For example, the predetermined value may be set to 0 km/h.

According to an embodiment, the vehicle state estimation apparatus 120 may correct only a section in which the speed of the vehicle 100 is equal to or greater than a predetermined value among the estimated driving periods as a driving period. For example, the predetermined value may be set to 1 km/h.

In operation 225, the vehicle state estimation apparatus 120 may provide the user with information related to the vehicle state. According to an embodiment, the vehicle state estimation apparatus 120 may provide the user with information related to the vehicle state estimated in operation 210 and/or information related to the vehicle state corrected in operation 220.

According to an embodiment, the vehicle state estimation apparatus 120 may display information related to the vehicle state through the display 130. According to an embodiment, the vehicle state estimation apparatus 120 may transmit the vehicle state information to an external electronic device via the communication circuit 140. The external electronic device may display the received vehicle state information through the display of the external electronic device.

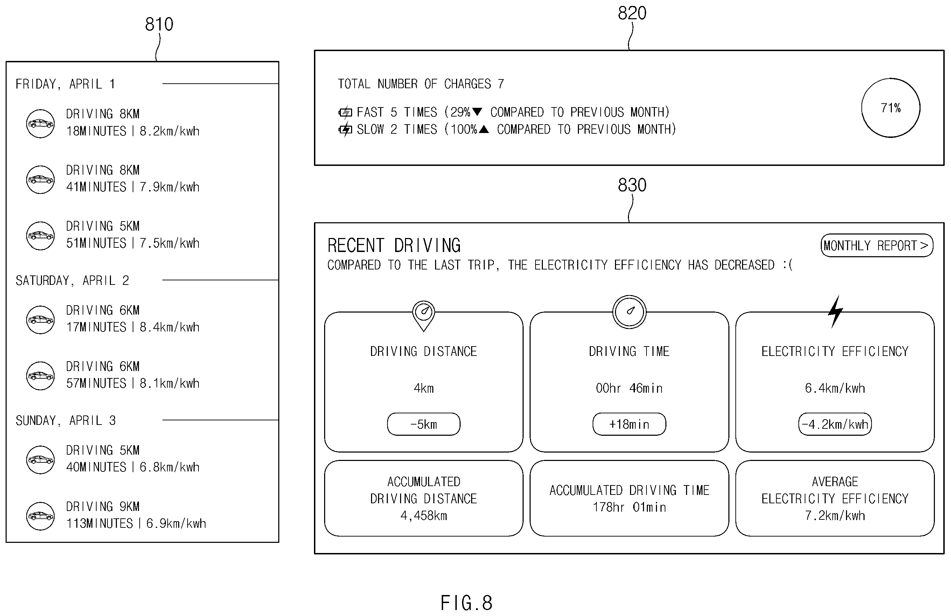

The vehicle state information provided to the user in operation 225 may be described later in detail with reference to FIG. 8.

FIG. 3 is a flowchart illustrating an operation of a vehicle state estimation apparatus according to an embodiment. FIG. 3 may be described with the components of FIG. 1.

The embodiment shown in FIG. 3 is merely one embodiment, and the order of steps according to various embodiments of the present invention may be different from that shown in FIG. 3, and some steps shown in FIG. 3 may be omitted, changed in order, or merged.

According to one embodiment, it may be understood that operations 305 to 320 are performed by the processor 123 of the vehicle state estimation apparatus 120.

With reference to FIG. 3, in operation 305, the vehicle state estimation apparatus 120 may obtain a current profile of the battery pack 110. According to an embodiment, the vehicle state estimation apparatus 120 may obtain the current profile of the battery pack 110 via the current sensor 121. For example, the vehicle state estimation apparatus 120 may obtain the current profile by measuring a current value of the battery pack 110 for a predetermined period of time via the current sensor 121.

In operation 310, the vehicle state estimation apparatus 120 may extract a low-frequency component of a predetermined frequency or less from the current profile obtained in operation 305. According to an embodiment, the vehicle state estimation apparatus 120 may extract a low-frequency component of a predetermined frequency or less from the current profile using an LPF.

In operation 315, the vehicle state estimation apparatus 120 may extract a flat section from a low-frequency component obtained in operation 310. According to an embodiment, the vehicle state estimation apparatus 120 may extract a flat section from a low-frequency component using an STD filter. According to an embodiment, the vehicle state estimation apparatus 120 may extract a flat section in which a current value is equal to or greater than a first predetermined current value and a change in current is maintained below a first threshold value over a predetermined period of time in the low-frequency component using an STD filter.

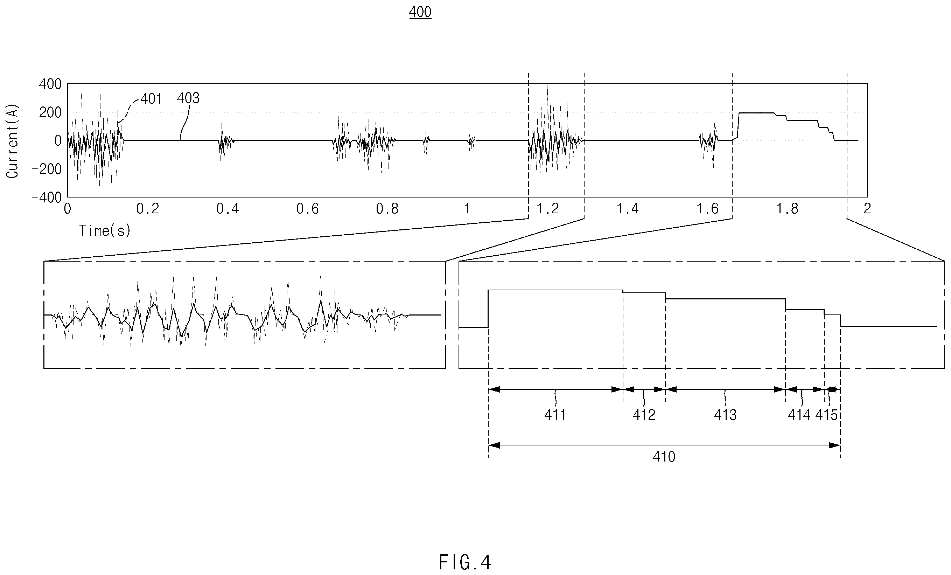

Operation 310 of extracting a low-frequency component from the current profile and operation 315 of extracting a flat section from the extracted low-frequency component may be described later in detail with reference to FIG. 4.

In operation 320, the vehicle state estimation apparatus 120 may estimate the flat section extracted in operation 315 as a charging period of the battery pack 110. Here, the charging period may mean a period in which the battery pack 110 receives power from an external power source. According to an embodiment, the vehicle state estimation apparatus 120 may estimate a section in which the current value is equal to or greater than a second predetermined current value among the flat sections extracted in operation 315 as the fast charging period. The vehicle state estimation apparatus 120 may also estimate a section in which the current value is less than the second predetermined current value among the flat sections extracted in operation 315 as a slow charging period. Here, the second predetermined current value may be greater than the first predetermined current value.

When the battery pack 110 of the vehicle 100 is being charged, the current value of the battery pack 110 may be maintained as a current value in the charging direction for a predetermined period of time. Accordingly, it is possible to reliably estimate the charging period of the battery pack 110 by extracting only the low-frequency components from the current profile in operation 310 and extracting a flat section from the low-frequency components extracted in operation 315.

FIG. 4 is a diagram illustrating an example of estimating a charging period of a battery pack by a vehicle state estimation apparatus according to an embodiment. FIG. 4 may be described with the components of FIG. 1.

The graph 400 of FIG. 4 may include a current profile and a low-frequency component of the battery pack 110. Here, the current profile may correspond to the current profile of the battery pack 110 that is obtained in operation 305 of FIG. 3. Also, the low-frequency component may correspond to the low-frequency component extracted in operation 310 of FIG. 3.

The low-frequency component may include the current flat section 410. The current flat section 410 may include a first flat section 411, a second flat section 412, a third flat section 413, a fourth flat section 414, and a fifth flat section 415. Each of the first to fifth flat sections 411 to 415 may refer to a section in which a current value is equal to or greater than a first predetermined current value and a change in current is maintained below a first threshold value over a predetermined period of time.

According to an embodiment, each of the first to fifth flat sections 411 to 415 may correspond to the flat section extracted in operation 315 of FIG. 3. In this case, the vehicle state estimation apparatus 120 may estimate each of the first to fifth flat sections 411 to 415 as a charging period of the battery pack 110.

According to an embodiment, the entire current flat section 410 may correspond to the flat section extracted in operation 315 of FIG. 3. In this case, the vehicle state estimation apparatus 120 may estimate the entire current flat section 410 as a charging period of the battery pack 110.

According to an embodiment, the vehicle state estimation apparatus 120 may estimate a section in which the current value is equal to or greater than a second predetermined current value among the first to fifth flat sections 411 to 415 as the fast charging period. The vehicle state estimation apparatus 120 may also estimate a section in which the current value is less than the second predetermined current value among the first fifth flat sections 411 to 415 as a slow charging period. Here, the second predetermined current value may be greater than the first predetermined current value. For example, the vehicle state estimation apparatus 120 may estimate the first flat section 411, the second flat section 412, and the third flat section 413 in which the current value equal to or greater than the second predetermined current value as a fast charging period and may estimate the fourth flat section 414 and the fifth flat section 415 in which the current value is less than the second predetermined current value as a slow charging period.

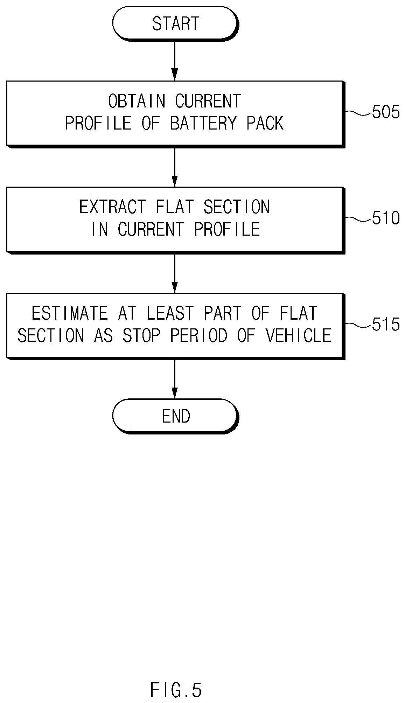

FIG. 5 is a flowchart illustrating an operation a vehicle state estimation apparatus according to an embodiment. FIG. 5 may be described with the components of FIG. 1.

The embodiment shown in FIG. 5 is merely one embodiment, and the order of steps according to various embodiments of the present invention may be different from that shown in FIG. 5, and some steps shown in FIG. 5 may be omitted, changed in order, or merged.

According to one embodiment, it may be understood that operations 505 to 515 are performed by the processor 123 of the vehicle state estimation apparatus 120.

With reference to FIG. 5, in operation 505, the vehicle state estimation apparatus 120 may obtain a current profile of the battery pack 110. According to an embodiment, the vehicle state estimation apparatus 120 may obtain the current profile of the battery pack 110 via the current sensor 121. For example, the vehicle state estimation apparatus 120 may obtain the current profile by measuring a current value of the battery pack 110 for a predetermined period of time via the current sensor 121.

In operation 510, the vehicle state estimation apparatus 120 may extract a flat section from the current profile obtained in operation 505. According to an embodiment, the vehicle state estimation apparatus 120 may extract a flat section from a current profile using an STD filter. According to an embodiment, the vehicle state estimation apparatus 120 may extract a flat section in which a change in current is maintained less than or equal to a second threshold value over a predetermined period of time using an STD filter.

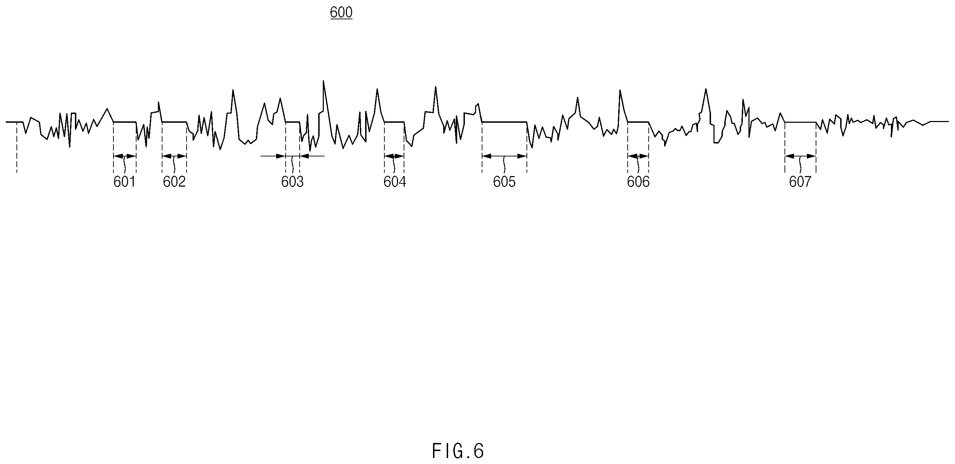

The operation of extracting a flat section from the current profile in operation 510 may be described later in detail with reference to FIG. 6.

In operation 515, the vehicle state estimation apparatus 120 may estimate at least part of the flat section extracted in operation 510 as a stop period of the vehicle 100. According to an embodiment, the vehicle state estimation apparatus 120 may estimate a section in which the current value is equal to or less than a third predetermined value among the flat sections as the stop period of the vehicle 100 . For example, the third predetermined value may be 0 A (ampere). In this case, the vehicle state estimation apparatus 120 may estimate a section in which the current value is 0 A and/or a section in which the current value is a negative number among the flat sections as the stopped period of the vehicle 100 . Here, a section in which the current value is negative may mean a period in which the current of the battery pack 110 flows in a direction in which the battery pack 110 is discharged.

When the vehicle 100 is stopped, the current value of the battery pack 110 may be maintained for a predetermined period of time. Accordingly, the stop period of the vehicle 100 may be reliably estimated by extracting a flat section from the current profile in operation 510.

FIG. 6 is a diagram illustrating an example of estimating a stop period of a vehicle by a vehicle state estimation apparatus according to an embodiment. FIG. 6 may be described with the components of FIG. 1.

The graph 600 of FIG. 6 may represent a current profile of the battery pack 110. Here, the current profile may correspond to the current profile of the battery pack 110 that is obtained in operation 505 of FIG. 5.

The current profile may include at least one current flat section 601 to 607. Each of the at least one current flat section 601 to 607 may refer to a section in which a change in current is maintained less than or equal to a second threshold value over a predetermined period of time.

According to an embodiment, at least one current flat section 601 to 607 may correspond to the flat section extracted in operation 510 of FIG. 5. In this case, the vehicle state estimation apparatus 120 may estimate at least part of the at least one current flat section 601 to 607 as a stop period of the vehicle 100. According to an embodiment, the vehicle state estimation apparatus 120 may estimate a section in which the current value is equal to or less than a third predetermined value among the at least one current flat section 601 to 607 as a stop period of the vehicle 100. For example, the third predetermined value may be 0 A (ampere).

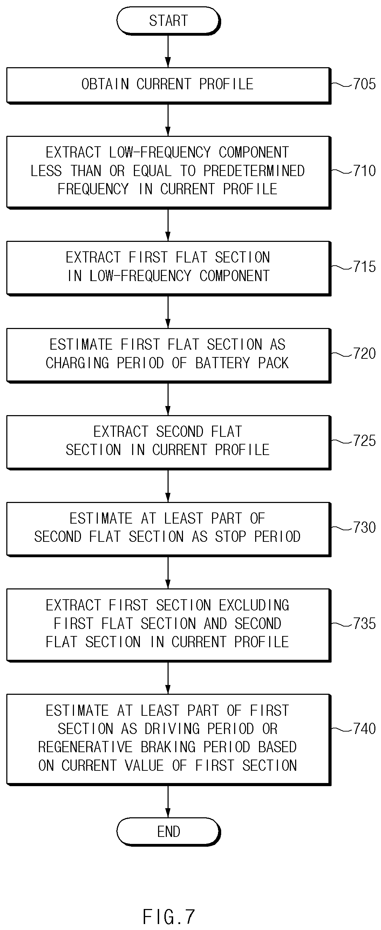

FIG. 7 is a flowchart illustrating an operation of a vehicle state estimation apparatus according to an embodiment. FIG. 7 may be described with the components of FIG. 1.

The embodiment shown in FIG. 7 is only one embodiment, and the order of steps according to various embodiments of the present invention may be different from that shown in FIG. 7, and some steps shown in FIG. 7 may be omitted, changed in order, or merged.

According to one embodiment, it may be understood that operations 705 to 740 are performed by the processor 123 of the vehicle state estimation apparatus 120.

With reference to FIG. 7, in operation 705, the vehicle state estimation apparatus 120 may obtain a current profile of the battery pack 110. According to an embodiment, the vehicle state estimation apparatus 120 may obtain the current profile of the battery pack 110 via the current sensor 121. For example, the vehicle state estimation apparatus 120 may obtain the current profile by measuring a current value of the battery pack 110 for a predetermined period of time via the current sensor 121.

In operation 710, the vehicle state estimation apparatus 120 may extract a low-frequency component of a predetermined frequency or less from the current profile obtained in operation 705. According to an embodiment, the vehicle state estimation apparatus 120 may extract a low-frequency component of a predetermined frequency or less from the current profile using an LPF.

In operation 715, the vehicle state estimation apparatus 120 may extract a first flat section in the low-frequency component obtained in operation 710. According to an embodiment, the vehicle state estimation apparatus 120 may extract a first flat section in the low-frequency component using the STD filter. According to an embodiment, the vehicle state estimation apparatus 120 extracts a first flat section in which the current value is equal to or greater than a first predetermined current value and a change in current is maintained below a first threshold value over a predetermined period of time in the low-frequency component using an STD filter.

In operation 720, the vehicle state estimation apparatus 120 may estimate the first flat section extracted in operation 715 as a charging period of the battery pack 110. Here, the charging period may mean a period in which the battery pack 110 receives power from an external power source. According to an embodiment, the vehicle state estimation apparatus 120 may estimate a section in which the current value is equal to or greater than the second predetermined current value among the first flat sections extracted in operation 715 as a fast charging period. The vehicle state estimation apparatus 120 may also estimate a section in which the current value is less than the second predetermined current value among the first flat sections extracted in operation 715 as the slow charging period. Here, the second predetermined current value may be greater than the first predetermined current value.

In operation 725, the vehicle state estimation apparatus 120 may extract a second flat section from the current profile obtained in operation 705. According to an embodiment, the vehicle state estimation apparatus 120 may extract a second flat section from the current profile using an STD filter. According to an embodiment, the vehicle state estimation apparatus 120 may extract a second flat section in which a change in current is maintained less than or equal to a second threshold value over a predetermined period of time using an STD filter.

In operation 730, the vehicle state estimation apparatus 120 may estimate at least part of the second flat section extracted in operation 725 as a stop period of the vehicle 100. According to an embodiment, the vehicle state estimation apparatus 120 may estimate a section in which the current value is equal to or less than a third predetermined value among the second flat section as a stop period of the vehicle 100 . For example, the third predetermined value may be 0 A (ampere). In this case, the vehicle state estimation apparatus 120 may estimate a section in which the current value is 0 A and/or a section in which the current value is a negative number among the second flat section as the stopped period of the vehicle 100. Here, a section in which the current value is negative may mean a period in which the current of the battery pack 110 flows in a direction in which the battery pack 110 is discharged.

In operation 735, the vehicle state estimation apparatus 120 may extract a first section excluding the first flat section extracted in operation 715 and the second flat section extracted in operation 725 in the current profile obtained in operation 705.

In operation 740, the vehicle state estimation apparatus 120 may estimate at least part of the first section as a driving period or a regenerative braking period based on the current value of the first section extracted in operation 735. According to an embodiment, the vehicle state estimation apparatus 120 may estimate a second section in which the current value is a positive number among the first section as a regenerative braking period. The vehicle state estimation apparatus 120 may also estimate a third section in which the current value is a negative number among the first section as a driving period. Here, the section in which the current value is a positive number may mean a period in which the current of the battery pack 110 flows in a direction in which the battery pack 110 is charged, and the section in which the current value is a negative number may mean a period in which the current of the battery pack 110 flows in a direction in which the battery pack 110 is discharged.

FIG. 8 is a diagram illustrating a screen provided through a display by a vehicle state estimation apparatus according to an embodiment. FIG. 8 may be described with the components of FIG. 1.

The vehicle state estimation apparatus 120 may display a first screen 810, a second screen 820, and/or a third screen 830 shown in FIG. 8 through the display 130 of the vehicle 100 and/or a display of an external electronic device. According to an embodiment, the vehicle state estimation apparatus 120 may displays the first screen 810, the second screen 810, and the third screen 830 based on the state of the vehicle 100 that is estimated through the operations of FIG. 3, FIG. 5, and/or FIG. 7.

The first screen 810 may include driving history information by date. The daily driving history information may include information about a driving distance, a driving time, and a driving speed.

The second screen 820 may include charge record information for the current month. The charge record information for the current month may include information about the total number of charges, the number of fast charges, the number of slow charges, the difference from the previous month, and the ratio between the number of fast charges and the number of slow charges.

The third screen 830 may include driving history information for the current month. The driving history information for the current month may include information about the latest driving distance, the accumulated driving distance, the latest driving time, the accumulated driving time, the latest electricity efficiency, and the average electricity efficiency.

Also, the terms such as "comprise", "include", or "have" used above implies that the corresponding component may be present unless otherwise stated specifically, and thus it should be construed as being able to further include other components rather than exclude other components. Unless otherwise defined herein, all terms including technical or scientific terms used herein have the same meanings as commonly understood by those skilled in the art to which the present invention belongs. It will be further understood that terms, such as those defined in commonly used dictionaries, should be interpreted as having a meaning that is consistent with their meaning in the context of the relevant art and should not be interpreted in an idealized or overly formal sense unless expressly so defined herein.

## Claims

1. A vehicle state estimation apparatus comprising:
a current sensor; and
a processor,
wherein the processor is configured to obtain a current profile of a battery pack of a vehicle via the current sensor, extract a low-frequency component of a predetermined frequency or less from the current profile, and estimate a first flat section in which a current value is equal to or greater than a first predetermined current value and a change in current is maintained below a first threshold value over a predetermined period of time in the low-frequency component as a charging period of the battery pack.

2. The vehicle state estimation apparatus of claim 1, wherein the charging period comprises a fast charging period and/or a slow charging period, and the processor is further configured to estimate at least part of the first flat section as the fast charging period or the slow charging section based on the current value of the first flat section.

3. The vehicle state estimation apparatus of claim 2, wherein the processor is further configured to estimate a section in which the current value is equal to or greater than a second predetermined current value among the first flat section as the fast charging period and estimate a section in which the current value is less than the second predetermined current value among the first flat section as the slow charging period.

4. The vehicle state estimation apparatus of claim 1, wherein the processor is further configured to estimate at least part of a second flat section in which a change in current is equal to or less than a second threshold value over a predetermined period of time in the current profile as a stop period of the vehicle.

5. The vehicle state estimation apparatus of claim 4, wherein the processor is further configured to estimate a section in which the current value is equal to or less than 0 A among the second flat section as the stop period.

6. The vehicle state estimation apparatus of claim 1, wherein the processor is further configured to extract a first section, excluding the first flat section and a second flat section in which a change in current is maintained less than or equal to a second threshold value over a predetermined period of time, in the current profile and estimate at least part of the first section as a driving period or a regenerative braking period of the vehicle based on the current value of the first section.

7. The vehicle state estimation apparatus of claim 6, wherein the processor is further configured to estimate a second section in which the current value is a positive number among the first section as the regenerative braking period and estimate a third section in which the current value is a negative number among the first section as the driving period.

8. The vehicle state estimation apparatus of claim 1, wherein the processor is further configured to acquire a parameter related to state estimation of the vehicle and additionally correct a state of the vehicle based on the parameter.

9. The vehicle state estimation apparatus of claim 8, wherein the parameter comprises driving speed information of the vehicle.

10. The vehicle state estimation apparatus of claim 1, wherein the processor is further configured to display information related to a state of the vehicle through a display of the vehicle.

11. The vehicle state estimation apparatus of claim 1, wherein the processor is further configured to transmit data comprising information related to a state of the vehicle to an external electronic device by using a communication circuit, and the data comprises at least one instruction causing the external electronic device to output a predetermined alarm including the information related to the state of the vehicle through a user interface.

12. A vehicle state estimation method comprising:
acquiring a current profile of a battery pack of a vehicle;
extracting a low-frequency component of a predetermined frequency or less from the current profile; and
estimating a first flat section in which a current value is equal to or greater than a first predetermined current value and a change in current is maintained below a first threshold value over a predetermined period of time in the low-frequency component as a charging period of the battery pack.

13. The vehicle state estimation method of claim 12, wherein the charging period comprises a fast charging period and/or a slow charging period, and estimating the first flat section comprises estimating at least part of the first flat section as the fast charging period or the slow charging section based on the current value of the first flat section.

14. The vehicle state estimation method of claim 12, further comprising estimating at least part of a second flat section in which a change in current is equal to or less than a second threshold value over a predetermined period of time in the current profile as a stop period of the vehicle.

15. The vehicle state estimation method of claim 14, further comprising:
extracting a first section, excluding the first flat section and a second flat section in which a change in current is maintained less than or equal to a second threshold value over a predetermined period of time, in the current profile; and
estimate at least part of the first section as a driving period or a regenerative braking period of the vehicle based on the current value of the first section.

16. The vehicle state estimation method of claim 12, further comprising:
acquiring parameters related to state estimation of the vehicle; and
correcting a state of the vehicle additionally based on the parameters.

17. A vehicle state estimation apparatus comprising:
a current sensor; and
a processor,
wherein the processor is configured to obtain a current profile of a battery pack of a vehicle via the current sensor, estimate a state of the vehicle based on the current profile, and display information related to the estimated state via an external electronic device.

18. The vehicle state estimation apparatus of claim 17, wherein the information comprises driving history information by date, and the driving history information by date comprises information about a driving time, a driving distance during the driving time, and a driving speed during the driving time.

19. The vehicle state estimation apparatus of claim 17, wherein the information comprises charge record information for the current month, and the charge record information for the current month comprises information about a total number of charges, a number of fast charges, a number of slow charges, a difference from the previous month, and a ratio between the number of fast charges and the number of slow charges.

20. The vehicle state estimation apparatus of claim 17, wherein the information comprises current month driving history information, and the current month driving history comprises information about a latest driving distance, an accumulated driving distance, a latest driving time, an accumulated driving time, a latest electricity efficiency, and an average electricity efficiency.
